# EUROPEAN PATENT SPECIFICATION

(11) **EP 0 544 047 B1**
(45) Date of publication and mention of the grant of the patent: **18.02.1998**
(21) Application number: 91830512.9
(22) Date of filing: 25.11.1991
(51) Int. Cl.: H01L 27/088, H01L 21/76

(54) **High current MOS transistor integrated bridge structure optimising conduction power losses**
Hochstrom-MOS-Transistor enthaltende integrierte Brückenstruktur mit optimierten Übertragungsleistungsverlusten
Structure intégrée en pont comportant des transistors MOS à courant élevé optimisant les pertes en puissance de conduction

(43) Date of publication of application: 02.06.1993
(73) Proprietor: SGS-THOMSON MICROELECTRONICS s.r.l., 20041 Agrate Brianza (Milano) (IT); CONSORZIO PER LA RICERCA SULLA MICROELETTRONICA NEL MEZZOGIORNO, 95121 Catania (IT)
(72) Inventor: Paparo, Mario, I-95037 San Giovanni La Punta (Catania) (IT); Aiello, Natale, I-95123 Catania (IT)
(74) Representative: Mittler, Enrico

(56) References cited:
- EP-A- 0 314 465
- DE-A- 3 400 973
- GB-A- 2 168 534
- PATENT ABSTRACTS OF JAPAN vol. 9, no. 280 (E-356)(2003) 8 November 1985 & JP-A-60 124 863
- INTERNATIONAL ELECTRON DEVICES MEETING 1987 6 December 1987, WASHINGTON, D.C , USA pages 766 - 769; C.CONTIERO ET AL.: 'Design of a high side driver in multipower-BCD and vipower technologies.'

## Description

This invention relates to a high current MOS transistor integrated bridge structure which optimises conduction power losses.

When converting an electrical signal from alternating current to direct current a Graetz bridge rectifier circuit consisting of two arms or half-bridges each comprising two transistors in series is generally used.

A known type of rectifier circuit using integrated MOS technology is described in US-A-4 949 142.

This provides for a pair of MOS transistors on each arm of the bridge coupled together in such a way that the source electrode of a first transistor in each arm is connected to the drain electrode of the second transistor in the arm. Coupling diodes are also placed between the source and drain electrodes of each transistor.

When this circuit is constructed in integrated form the coupled semiconductor regions, the transistor source and drain, the diodes and the gate electrodes are constructed on a single semiconductor plate or substrate, minimising the area of silicon used and producing a faster speed in the circuit.

This form of construction, although optimising the area of the semiconductor plate and ensuring satisfactory speed in the circuit so obtained cannot be constructed with reasonable conversion efficiency.

The resulting monolithic integrated circuit in fact has parasitic transistors which cause considerable power losses. While the circuit is functioning there are high current flows which cause excessive dissipation of the power at parasites and connections, which can result in breakage of the connections, the parasites themselves and adjacent integrated components forming the bridge, with the result that the bridge fails to function.

DE-A- 3 400 973 discloses another MOS transistor integrated bridge structure of known type.

IEEE IEDM 6/12/87 pgs. 766-769 discloses a high side driver in either multipower-BCD or VIPower technology.

The object of this invention is to provide a high current MOS transistor integrated bridge structure which optimises conduction power losses and can be constructed in a monolithic manner on a single plate of silicon.

In accordance with the invention this object is achieved through a high current MOS transistor integrated bridge structure as defined in claim 1.

In this way the presence of the type P insulation regions causes the effect of the parasitic transistors which form between the first and second transistors of the first and second arm of the bridge to be cancelled out through the effect of the integrated monolithic construction.

In particular there is a reduction in dissipated power which is also due to the fact that this structure has a vertical current flow in its central portion and can be used to tap the higher potential node of the rectified voltage directly on the substrate of the device.

The features of this invention will be more apparent from a practical embodiment illustrated by way of a non-restrictive example in the appended drawing in which:
Figure 1 shows a first circuit diagram of a bridge rectifier not forming part of the invention,
Figure 2 shows an integrated embodiment of a bridge rectifier with an equivalent circuit as illustrated in Figure 1,
Figure 3 shows an alternative circuit diagram to that shown in Figure 1, according to the invention,
Figure 4 shows an integrated embodiment of the circuit diagram illustrated in Figure 3.

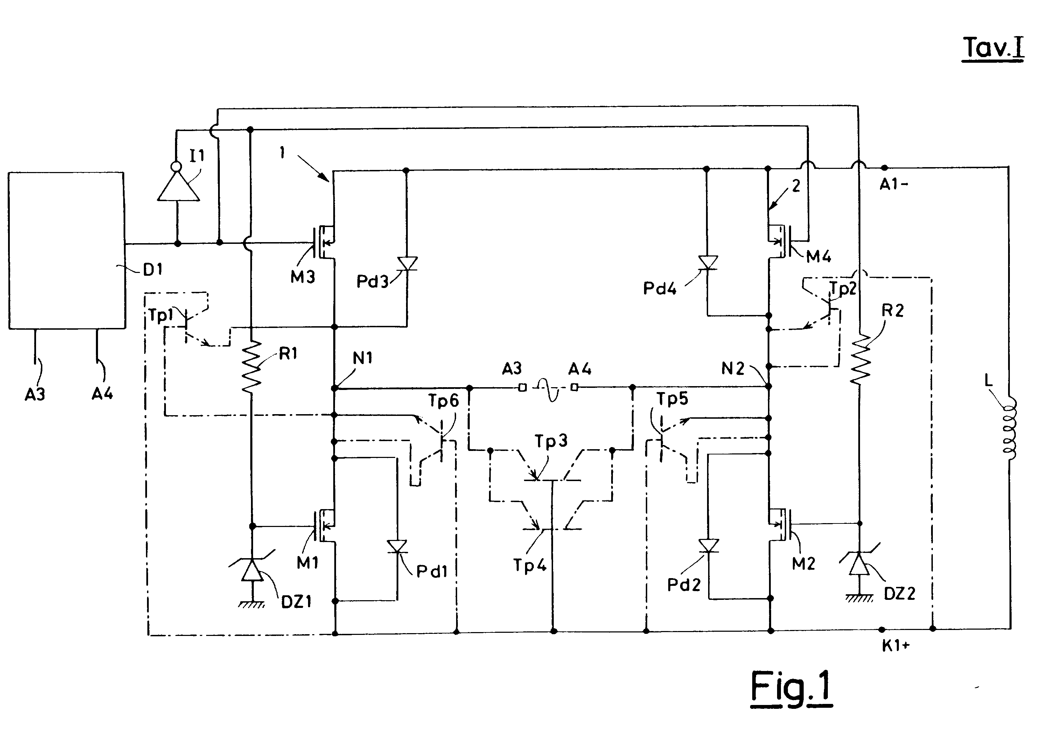

With reference to Figure 1, this shows a Graetz bridge rectifier circuit comprising two arms or half-bridges 1, 2 each comprising a first and a second transistor M3 and M1 in arm 1, and M4 and M2 in arm 2. All four transistors M1, M2, M3, M4 are of the n channel MOS type. The sources of transistors M3, M4 are connected together and to a negative potential output terminal A1, the gates receive an output signal directly and via an inverter 11 respectively from a drive device D1 which in turn receives a signal which is present at alternating current inputs A3, A4. The drains of transistors M3, M4 are connected, at circuit nodes N1, N2, to the sources of transistors M1, M2 respectively. The drains of transistors M1, M2 are connected to positive potential output K1, the gates are earthed through zener diodes DZ1, DZ2 and receive the output signal from drive device D1 through inverter I1 and directly respectively. Intrinsic resistances R1, R2 of the integrated structure are placed between the gate of transistor M1 and the output of inverter I1 and between the gate of transistor M2 and the output of pilot device D1 respectively. A load L is connected between an output terminal A1 at a negative potential and output K1 at a positive potential.

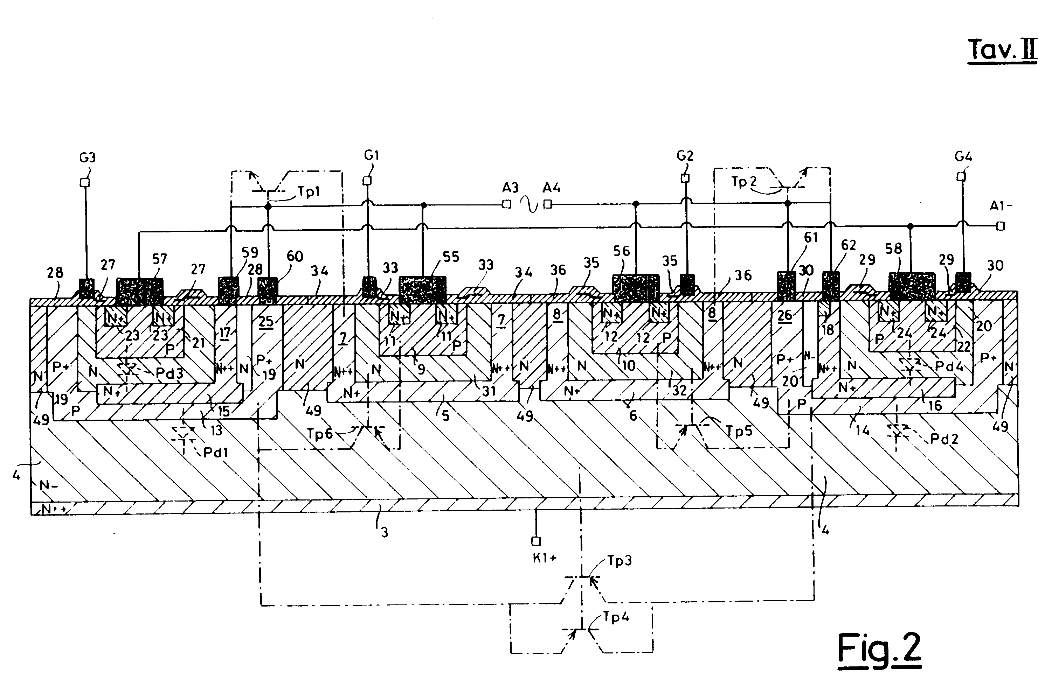

A monolithic embodiment of the bridge circuit described above is illustrated in Figure 2 and comprises an N++ type substrate 3 forming output terminal K1 with a positive potential, which is overlaid by a type N-epitaxial layer 4.

Within epitaxial layer 4 there are regions forming transistor units M1, M2, M3, M4.

While transistors M1, M2 are formed directly in the epitaxial layer, transistors M3, M4 are constructed in type P pockets 13, 14 respectively which are directly contained in epitaxial layer 4, and which extend to the surface with subregions 25, 26 of type P+ contained in epitaxial layer 49. The function of these pockets will be explained below.

Transistor M3 is formed of an enriched N+ drain region 15 in an L shape with a lateral region 17 of type N++ which extends to the surface.

Region 15 together with region 17 bounds on its two sides a type N drain region 19. Region 19 contains a body region 21 of type P which in turn contains N+ type source regions 23.

The gate of M3 is formed from a pair of regions 27 embedded in a surface insulating layer 28. The gate electrode is indicated by G3.

Regions 21 and 15, 19 represent the anode and the cathode of a Pd3 diode placed in parallel between the source and the drain of transistor M3.

Transistor M4 is formed from a type N+ enriched drain region 16 of an L shape with a lateral type N++ region 18 which extends to the surface.

Region 16 together with region 18 bounds on its two sides a type N drain region 20. Region 20 contains a body region 22 of type P which in turn contains type N+ source regions 24.

The gate of M4 is formed by a pair of regions 29 embedded in a surface insulating layer 30. The gate electrode is indicated by G4.

Regions 22 and 16, 20 represent the anode and the cathode of a diode Pd4 placed in parallel with transistor M4.

Transistor M1 is formed from an enriched type N+ drain region 5 with lateral regions 7 which extend to the surface.

Region 5 together with regions 7 contains a type N drain region 31. Within region 31 there is a type P body region 9 and within this type N+ source regions 11.

The gate of M1 is formed from a pair of regions 33 embedded in a surface insulating layer 34. The gate electrode is indicated by G1.

Regions 13, 4 represent the anode and the cathode of a diode Pd1 placed in parallel with transistor M1.

Transistor M2 is formed of an enriched type N+ drain region 6 with lateral regions 8 which extend to the surface.

Region 6 together with regions 8 contains a type N drain region 32. Within region 32 there is a type P body region 10 and within this type N+ source regions 12.

The gate of M2 is formed from a pair of regions 35 embedded in a surface insulating layer 36. The gate electrode is indicated by G2.

Regions 14, 4 represent the anode and the cathode of a diode Pd2 placed in parallel with transistor M2.

Metal strips 55, 56, 57, 58, 59, 60, 61, 62 are present on the surface and connect regions 9, 11, 17, 25 to input A3, regions 10, 12, 61, 62 to input A4, regions 21, 23 and regions 22, 24 to negative potential output terminal A1.

Within the integrated monolithic structure there are parasitic transistors Tp1, Tp2, Tp3, Tp4, Tp5, Tp6 indicated by dashed lines which in the absence of regions 13, 25, 14, 26 or in a structure in which all four MOS are directly made in an earthed substrate, such as e.g. in the patent application mentioned in the introduction, are therefore active with consequent losses of power in the structure.

Parasitic transistor Tp1 has a base coinciding with region 25, an emitter with region 17 and a collector with region 7.

In circuit terms, as can be seen in Figure 1, the emitter and the base of Tp1 are connected to input A3, and the collector is connected to positive potential output terminal K1.

Parasitic transistor Tp2 has a base coinciding with region 26, an emitter with region 18 and a collector with region 6.

In circuit terms the emitter and the base of Tp2 are connected to input A4, and the collector is connected to positive potential output terminal K1.

Parasitic transistor Tp3 has a base coinciding with epitaxial layer 4, an emitter with region 14 and a collector with region 13.

In circuit terms the emitter and the collector of Tp3 are connected to inputs A4, A3, and the base is connected to positive potential terminal K1.

Parasitic transistor Tp4 has a base coinciding with epitaxial layer 4, the emitter with region 13 and the collector with region 14.

In circuit terms the emitter and the collector of Tp4 are connected to inputs A3, A4, and the base to positive potential terminal K1.

Parasitic transistor Tp5 has a base coinciding with regions 32, 6, 8, the emitter coincides with region 10 and the collector with region 14, 26.

In circuit terms the base of Tp5 is connected to positive potential terminal K1, and the emitter and collector are connected to input A4.

Parasitic transistor Tp6 has a base coinciding with region 31, 5, 7, the emitter coincides with region 9 and the collector with region 13, 25.

In circuit terms the base of Tp6 is connected to positive potential terminal K1, and the emitter and collector are connected to input A3.

The structure described above is in its central zone of the vertical current flow type and has the advantage that it can tap the higher potential node of the rectified voltage directly on substrate 3, instead of at the surface of the device, improving the dissipatable power.

As a result of the presence of regions 13, 25; 14, 26 which are not earthed, but are connected to inputs A3, A4 respectively, parasitic transistors Tp1, Tp2 are switched off as the base and emitter are short-circuited. Also parasitic transistors Tp5, Tp6 are inactive in that their emitter and collector regions are short-circuited together.

As far as parasitic transistors Tp3, Tp4 are concerned, the loss of current due to these is negligible because these are lateral PNP transistors with a very wide base and therefore an extremely low gain.

With reference to diodes Pd1, Pd2, Pd3, Pd4, when the potential on input A3 is positive M1, M4 conduct and diodes Pd1, Pd4 make no contribution as they are short-circuited by transistors M1, M4. Diodes Pd3, Pd4 are inhibited.

A similar situation arises in the case of the negative potential on input A3. In this case Pd2, Pd3 are short-circuited by transistors M2, M3 which are conducting and placed in parallel, while Pd1, Pd4 are inhibited.

The pilot circuit for gates G1, G2 uses suitable load pumping techniques to pilot gates M1 and M2 which require a greater potential than the positive potential available on the substrate coinciding with positive potential output terminal K1 of a value equal to at least the voltage required to make the MOS fully conducting.

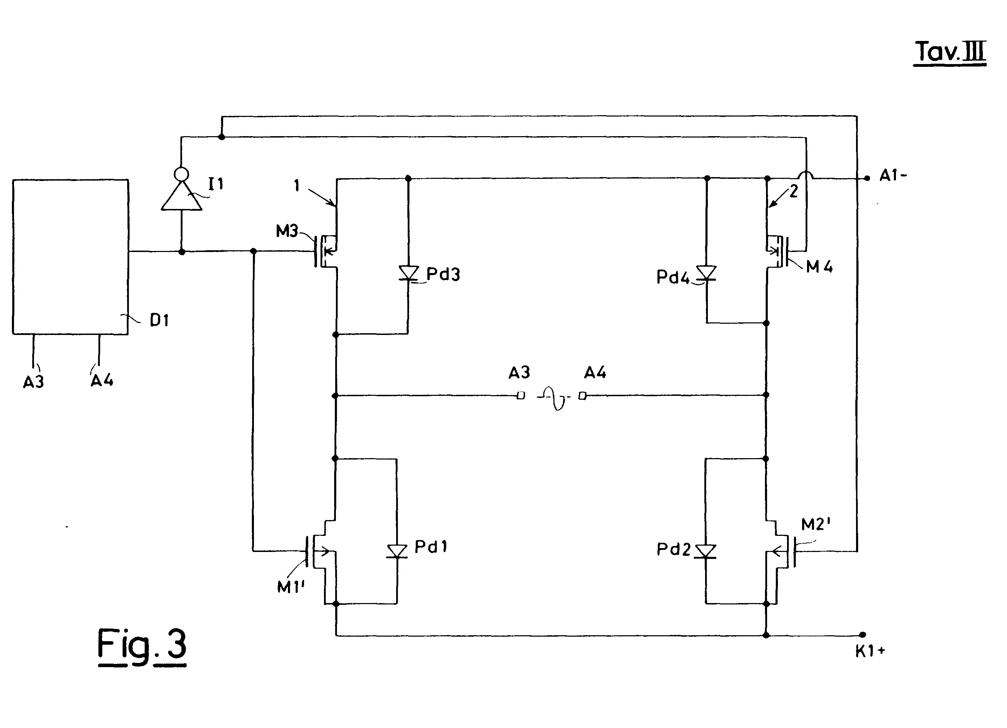

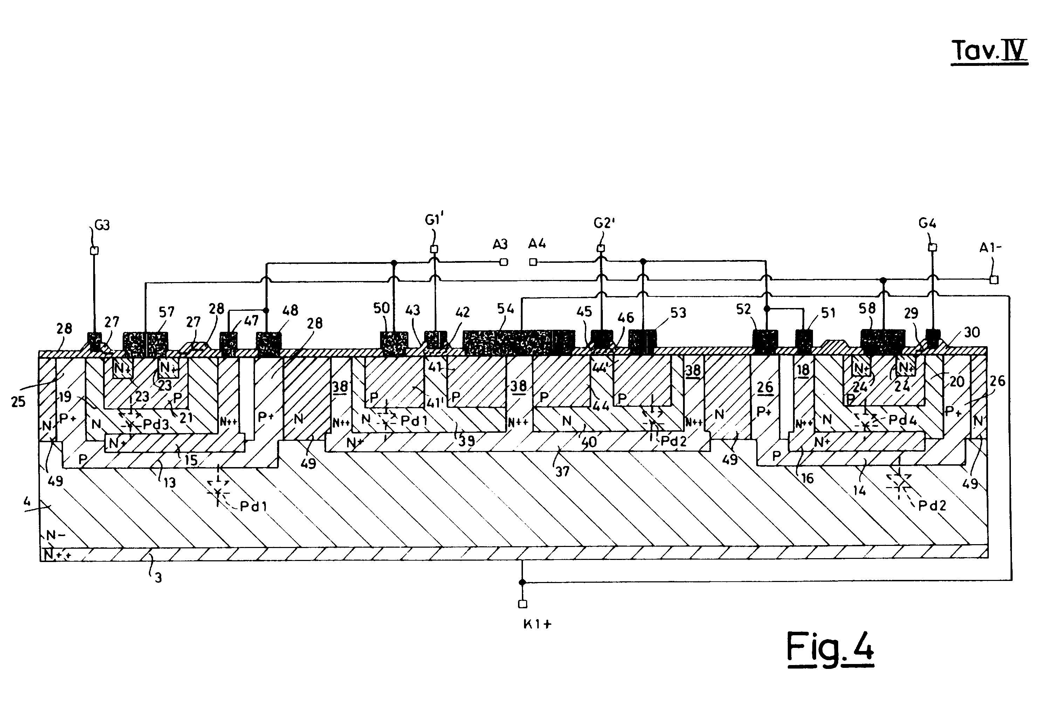

A change in the structure described above is illustrated in Figures 3, 4.

Figure 3 differs from Figure 1 by the presence of p channel MOS M1', M2' instead of n channel MOS M1, M2.

As illustrated in Figure 4, transistors M1', M2' are constructed within epitaxial layer 4, 49 and include a type N+ region 37 with type N++ regions 38 which extend to the surface. Within region 37 there are body regions 39 for transistor M1', 40 for transistor M2', both of type N.

Transistor M1' also includes a type P source region 41 and drain region 41' within body region 39.

The gate of M1' is formed by a region 42 embedded in a surface insulating layer 43. The gate electrode is indicated by G1'.

Transistor M2' also includes within body region 40 a type P source region 44 and drain region 44'.

The gate of M2' is formed by a region 45 embedded in a surface insulating layer 46. The gate electrode is indicated by G2'.

On the surface of the structure there are also metal strips 47, 48, 50 which connect regions 15, 13, 41' to input A3, strips 51, 52, 53 which connect regions 16, 14, 44' to input A4 and a strip 54 connecting regions 37, 41, 44 to positive potential output terminal K1 and strips 57, 58 which connect regions 23, 24 to output terminal A1.

Examination of Figure 3 will reveal the extreme simplicity of the bridge piloting in this second version because the piloting voltages for transistor gates M1', M2', M3, M4 always lie between the more positive potential present on output terminal K1 and the more negative potential present at output terminal A1, with an obvious advantage for piloting device D1.

In the case of both the circuit in Figure 1 and that in Figure 3 it is possible to construct the corresponding piloting devices in monolithic form on the same plate which holds the structure forming a self-supplied synchronous converter.

The structure according to the invention can be used in multiphase circuits in all structural configurations and the bridge arms can vary from a minimum of 1 to N.

All the dimensions of the plate used are linked to the maximum convertible power and the total number of integratable unit arms.

The structure to which this invention relates may be used with generator (VA3-VA4) and load L inverted, thus producing bridges with N arms for applications in motor control and static inverters.

Given the form of the structure, the limitation on the feed voltage for the bridge is imposed by the vertical current flow MOS and isolated drain devices (typically 60-100 volts), while the top arms of the bridge (vertical current flow MOS transistors) can have very much higher breakdown voltages (around 2000 volts).

Replacing the two MOS transistors M3, M4 with vertical current flow and isolated drain with a configuration of MOS transistors with a vertical current flow and isolated drain connected together in series it is possible to increase the maximum operating voltage of the bridge to a value equal to N times the breakdown voltage of the transistors, where N is the number of transistors placed in series with each other.

If desired the device described may also include one or more insulating pockets 13, 14; 25, 26 connected to a potential which is not greater than the substrate potential, in which one or more components of the control and piloting device for the two arms of the bridge are housed.

## Claims

1. An integrated structure for a MOS transistor high current bridge having at least two bridge arms (1, 2), each including a first n-channel MOS transistor (M3, M4) and a second p-channel MOS transistor (M1', M2') which are serially connected to each other between positive and negative output bridge terminals (K1, A1) and have a common circuit node (N1, N2) connected to a respective alternating current input terminal (A3, A4), the structure comprising:
a) an N++ type substrate (3) having a bottom surface connected to the positive output bridge terminal (K1);
b) an N-type epitaxial layer (4) formed over the substrate (3) and having a top surface;
c) a U-shaped P-type isolation region (13, 14) formed in the epitaxial layer (4) and electrically coupled to a respective alternating current input terminal (A3, A4) for each bridge arm (1, 2), said isolation region (13, 14) extending from the epitaxial layer top surface and completely surrounding doped source regions (23, 24) formed on a body region (21, 22) and doped drain regions (15, 17; 16, 18) of the respective first MOS transistor (M3, M4), said source regions (23, 24) being electrically coupled to the negative output bridge terminal (A1) and said drain regions (15, 17; 16, 18) being electrically coupled to a respective alternating current input terminal (A3, A4); said drain regions formed of N⁺ drain regions (15,17 ; 16,18) in an L shape ;
d) a U-shaped N+type region (5, 7; 6, 8; 37, 38) for each bridge arm (1, 2), said N-type region (5, 7; 6, 8; 37, 38) extending from the epitaxial layer top surface outside said isolation region (13, 14) and completely surrounding a n-type body region (39, 40) having doped source regions (41, 44) and doped drain regions (41', 44') of the respective second MOS transistor (M1', M2'), said source regions (41, 44) being electrically coupled to a respective alternating current input terminal (A3, A4) and said drain regions (41', 44') being electrically coupled to the positive output bridge terminal (K1).

## Patentansprüche

1. Integrierter Aufbau für eine Hochstrom-MOS-Transistorbrücke mit mindestens zwei Brückenarmen (1, 2), von denen jeder einen ersten n-Kanal-MOS-Transistor (M3, M4) und einen zweiten p-Kanal-MOS-Transistor (M1', M2') enthält, die in Reihe miteinander zwischen einem positiven und einem negativen Brückenausgangsanschluß (K1, A1) geschaltet sind und einen gemeinsamen Schaltungsknoten (N1, N2) aufweisen, der mit einem entsprechenden Wechselstromeingangsanschluß (A3, A4) verbunden ist, wobei der Aufbau aufweist:
a) ein N⁺⁺-Substrat (3) mit einer mit dem positiven Brückenausgangsanschluß (K1) verbundenen Bodenoberfläche;
b) einer über dem Substrat (3) gebildeten N-Epitaxieschicht (4) mit einer oberen Oberfläche;
c) einen U-förmigen P-Isolationsbereich (13, 14), der in der Epitaxieschicht (4) gebildet ist und mit einem entsprechenden Wechselstromeingangsanschluß (A3, A4) für jeden Brückenarm (1, 2) verbunden ist, wobei sich der Isolationsbereich (13, 14) von der oberen Oberfläche der Epitaxieschicht erstreckt und vollständig auf einem Körperbereich (21, 22) gebildete dotierte Sourcebereiche (23, 24) und dotierte Drainbereiche (15, 17; 16, 18) des entsprechenden ersten MOS-Transistors (M3, M4) umgibt, die Sourcebereiche (23, 24) elektrisch mit dem negativen Brückenausgangsanschluß (A1) verbunden sind und die Drainbereiche (15, 17; 26, 18) elektrisch mit einem entsprechenden Wechselstromeingangsanschluß (A3, A4) verbunden sind;
die Drainbereiche aus N⁺-Drainbereichen (15, 17; 16, 18) in einer L-Form gebildet sind;
d) einen U-förmigen N⁺-Bereich (5, 7; 6, 8; 37, 38) für jeden Brückenarm (1, 2), wobei sich der N-Bereich (5, 7; 6, 8; 37, 38) von der oberen Oberfläche der Epitaxieschicht außerhalb des Isolationsbereiches (13, 14) erstreckt und vollständig einen n-Körperbereich (39, 40) umgibt, der dotierte Sourcebereiche (41, 44) und dotierte Drainbereiche (41', 44') der entsprechenden zweiten MOS-Transistoren (M1', M2') aufweist, wobei die Sourcebereiche (41, 44) elektrisch mit einem entsprechenden Wechselstromeingangsanschluß (A3, A4) verbunden sind und die Drainbereiche (41', 44') elektrisch mit dem positiven Brückenausgangsanschluß (K1) verbunden sind.

## Revendications

1. Structure intégrée destinée à un pont pour courant élevé à transistors MOS possédant au moins deux branches de pont (1, 2), chacune comportant un premier transistor MOS à canal n (M3, M4) et un deuxième transistor MOS à canal p (M1', M2') qui sont connectés en série l'un avec l'autre entre des bornes de pont de sortie positive et négative (K1, A1) et possèdent un noeud de circuit commun (N1, N2) connecté à une borne d'entrée de courant alternatif respective (A3, A4), la structure comprenant :
a) un substrat de type N⁺⁺ (3) possédant une surface de fond connectée à la borne de pont de sortie positive (K1);
b) une couche épitaxiale de type N (4) formée sur le substrat (3) et possédant une surface de dessus ;
c) une région d'isolation de type P en forme de U (13, 14) formée dans la couche épitaxiale (4) et électriquement couplée à une borne d'entrée de courant alternatif respective (A3, A4) pour chaque branche de pont (1, 2), ladite région d'isolation (13, 14) s'étendant depuis la surface de dessus de la couche épitaxiale et entourant complètement des régions de source dopées (23, 24), formées sur une région de corps (21, 22) et des régions de drain dopées (15, 17 ; 16, 18) du premier transistor MOS respectif (M3, M4), lesdites régions de source (23, 24) étant électriquement couplées à la borne de pont de sortie négative (A1) et lesdites régions de drain (15, 17 ; 16, 18) étant électriquement couplées à une borne d'entrée de courant alternatif respective (A3, A4), lesdites régions de drain étant formées de régions de drain N⁺ (15, 17 ; 16, 18) suivant une forme en L;
d) une région de type N⁺ en forme de U (5, 7 ; 6, 8 ; 37, 38) pour chaque branche de pont (1, 2), ladite région de type N (5, 7 ; 6, 8 ; 37, 38) s'étendant depuis la surface de dessus de la couche épitaxiale à l'extérieur de ladite région d'isolation (13, 14) et entourant complètement une région de corps de type N (39, 40) ayant des régions de source dopées (41, 44) et des régions de drain dopées (41', 44') du deuxième transistor MOS respectif (M1', M2'), lesdites régions de source (41, 44) étant électriquement couplées à une borne d'entrée de courant alternatif respective (A3, A4) et lesdites régions de drain (41', 44') étant électriquement couplées à la borne de pont de sortie positive (K1).
